(19) **Europäisches Patentamt / European Patent Office / Office européen des brevets**

(11) **EP 3 978 644 A1**

(12) **EUROPEAN PATENT APPLICATION**
published in accordance with Art. 153(4) EPC

(43) Date of publication:
06.04.2022 Bulletin 2022/14

(21) Application number: 20839994.9

(22) Date of filing: 15.07.2020

(51) International Patent Classification (IPC):
*C23C 14/54* (2006.01)   *C23C 14/32* (2006.01)

(52) Cooperative Patent Classification (CPC):
C23C 14/32; C23C 14/54

(86) International application number:
PCT/JP2020/027465

(87) International publication number:
WO 2021/010415 (21.01.2021 Gazette 2021/03)

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME
Designated Validation States:
KH MA MD TN

(30) Priority: 16.07.2019   JP 2019131218
28.11.2019   JP 2019215681

(71) Applicant: KABUSHIKI KAISHA KOBE SEIKO SHO
(KOBE STEEL, LTD.)
Hyogo 651-8585 (JP)

(72) Inventors:
• KUNISUE, Akinobu
Takasago-shi, Hyogo 676-8670 (JP)
• TAKAHASHI, Tetsuya
Takasago-shi, Hyogo 676-8670 (JP)
• NAKASHIMA, Yosuke
Takasago-shi, Hyogo 676-8670 (JP)

(74) Representative: TBK
Bavariaring 4-6
80336 München (DE)

(54) **MACHINE LEARNING METHOD, MACHINE LEARNING DEVICE, MACHINE LEARNING PROGRAM, COMMUNICATION METHOD, AND FILM-FORMING DEVICE**

(57) A state variable including at least one physical quantity related to performance evaluation of film formation and at least one film formation condition is observed, a reward for a determination result of the at least one film formation condition is calculated based on the state variable, a function for determining the at least one film formation condition from the state variable is updated based on the reward, the film formation condition under which the reward is obtained the most is determined by repeating the updating of the function, the at least one film formation condition is at least one of a first parameter related to a vacuum evacuation system, a second parameter related to a heating and cooling system, a third parameter related to an evaporation source system, a fourth parameter related to a table system, and a fifth parameter related to a process gas system, and the at least one physical quantity is at least one of a film quality characteristic, a mechanical characteristic, and a physical characteristic that are related to the film.

FIG.2

## Description

### Technical Field

The present disclosure relates to a technique for learning a film formation condition by machine learning.

### Background Art

In recent years, in order to manufacture a cutting tool having high wear resistance, a hard film of TiN, TiAlN, CrN, or the like is formed by a physical vapor deposition (PVD) on a base material to be the cutting tool (e.g., Patent Literature 1). In order to manufacture a tool having high wear resistance, it is required to appropriately determine a film formation condition.

However, film formation conditions have conventionally been determined relying on many years of experience by a skilled technician. Therefore, it has been difficult to easily determine an appropriate film formation condition.

### Citation List

### Patent Literature

Patent Literature 1: JP 2014-114507 A

### Summary of Invention

The present invention has been made to solve such a problem, and an object of the present invention is to provide a machine learning method and the like that can easily determine an appropriate film formation condition.

In recent years, various services related to machine learning including deep learning have been provided on a cloud, and users can easily use the services. The present inventor has found that an appropriate film formation condition can be easily determined by machine learning with the film formation condition and a physical quantity related to the performance evaluation of film formation, and has been conceive of the present invention.

A machine learning method according to one aspect of the present invention is a machine learning method in which a machine learning device determines a film formation condition of a film forming device that forms a film on a workpiece that is a base material, the film forming device including a vacuum evacuation system that evacuates a chamber, a heating and cooling system that heats and cools the chamber, an evaporation source system that evaporates a target, a table system on which a workpiece is placed, a process gas system that introduces a process gas into the chamber, and an etching system, the machine learning method including: acquiring a state variable including at least one physical quantity related to performance evaluation of film formation and at least one film formation condition; calculating a reward for a determination result of the at least one film formation condition based on the state variable; updating, based on the reward, a function for determining the at least one film formation condition from the state variable; and determining a film formation condition under which the reward is obtained most by repeating update of the function, in which the at least one film formation condition is at least one of a first parameter related to the vacuum evacuation system, a second parameter related to the heating and cooling system, a third parameter related to the evaporation source system, a fourth parameter related to the table system, and a fifth parameter related to the process gas system, and the at least one physical quantity is at least one of a film quality characteristic, a mechanical characteristic, and a physical characteristic that are related to the film.

A machine learning device according to another aspect of the present invention is a machine learning device that determines a film formation condition of a film forming device that forms a film on a workpiece that is a base material, the film forming device including a vacuum evacuation system that evacuates a chamber, a heating and cooling system that heats and cools the chamber, an evaporation source system that evaporates a target, a table system on which a workpiece is placed, a process gas system that introduces a process gas into the chamber, and an etching system, the machine learning device including: a state acquisition unit that acquires a state variable including at least one physical quantity related to performance evaluation of film formation and at least one film formation condition; a reward calculation unit that calculates a reward for a determination result of the at least one film formation condition based on the state variable; an update unit that updates, based on the reward, a function for determining the at least one film formation condition based on the state variable; and a determination unit that determines a film formation condition under which the reward is obtained most by repeating update of the function, in which the at least one film formation condition is at least one of a first parameter related to the vacuum evacuation system, a second parameter related to the heating and cooling system, a third parameter related to the evaporation source system, a fourth parameter related to the table system, and a fifth parameter related to the process gas system, and the at least one physical quantity is at least one of a film quality characteristic, a mechanical characteristic, and a physical characteristic that are related to the film.

A machine learning program according to yet another aspect of the present invention is a computer-readable machine learning program that causes a computer to function as a machine learning device that determines a film formation condition of a film forming device that forms a workpiece that is a base material, the film forming device including a vacuum evacuation system that evacuates a chamber, a heating and cooling system that heats and cools the chamber, an evaporation source system that evaporates a target, a table system on which a workpiece is placed, a process gas system that introduces a process gas into the chamber, and an etching system, the machine learning program causing a computer to function as: a state acquisition unit that acquires a state variable including at least one physical quantity related to performance evaluation of film formation and at least one film formation condition; a reward calculation unit that calculates a reward for a determination result of the at least one film formation condition based on the state variable; an update unit that updates, based on the reward, a function for determining the at least one film formation condition based on the state variable; and a determination unit that determines a film formation condition under which the reward is obtained most by repeating update of the function, in which the at least one film formation condition is at least one of a first parameter related to the vacuum evacuation system, a second parameter related to the heating and cooling system, a third parameter related to the evaporation source system, a fourth parameter related to the table system, and a fifth parameter related to the process gas system, and the at least one physical quantity is at least one of a film quality characteristic, a mechanical characteristic, and a physical characteristic that are related to the film.

A communication method according to still another aspect of the present invention is a communication method for a film forming device when machine learning a film formation condition of the film forming device that forms a workpiece that is a base material, the film forming device including a vacuum evacuation system that evacuates a chamber, a heating and cooling system that heats and cools the chamber, an evaporation source system that evaporates a target, a table system on which a workpiece is placed, a process gas system that introduces a process gas into the chamber, an etching system, and a communication unit, the communication method including: observing a state variable including at least one physical quantity related to performance evaluation of film formation after film formation is executed and at least one film formation condition; and transmitting the state variable to a network via the communication unit and receiving at least one machine-learned film formation condition, in which the at least one film formation condition is at least one of a first parameter related to the vacuum evacuation system, a second parameter related to the heating and cooling system, a third parameter related to the evaporation source system, a fourth parameter related to the table system, and a fifth parameter related to the process gas system, and the at least one physical quantity is at least one of a film quality characteristic, a mechanical characteristic, and a physical characteristic that are related to the film.

A film forming device according to still another aspect of the present invention is a film forming device that forms a film on a workpiece that is a base material, the film forming device including: a vacuum evacuation system that evacuates a chamber; a heating and cooling system that heats and cools the chamber; an evaporation source system that evaporates a target; a table system on which a workpiece is placed; a process gas system that introduces a process gas into the chamber; an etching system; a state observation unit that observes a state variable including at least one physical quantity related to performance evaluation of film formation after film formation is executed and at least one film formation condition; and a communication unit that transmits the state variable to a network and receives at least one machine-learned film formation condition, in which the at least one film formation condition is at least one of a first parameter related to the vacuum evacuation system, a second parameter related to the heating and cooling system, a third parameter related to the evaporation source system, a fourth parameter related to the table system, and a fifth parameter related to the process gas system, and the at least one physical quantity is at least one of a film quality characteristic, a mechanical characteristic, and a physical characteristic that are related to the film.

According to the present invention, it is possible to easily determine an appropriate film formation condition for a base material.

**Brief Description of Drawings**

FIG. 1 is an overall configuration view of a film forming device applied to a machine learning system according to a first embodiment.

FIG. 2 is an overall configuration view of the machine learning system according to the first embodiment.

FIG. 3 is a flowchart showing an example of processing in the machine learning system shown in FIG. 2.

FIG. 4 is a view showing an example of a film formation condition.

FIG. 5 is a view showing an example of a physical quantity according to the first embodiment.

FIG. 6 is a view showing an example of a physical quantity according to a second embodiment.

FIG. 7 is a view showing an example of a physical quantity according to a third embodiment.

FIG. 8 is a view showing an example of a physical quantity according to a fourth embodiment.

FIG. 9 is an overall configuration view of a machine learning system according to a modification of the present invention.

**Description of Embodiments**

Embodiments of the present invention will be described below with reference to the accompanying drawings. Note that the following embodiments are examples embodying the present invention and are not intended to limit the technical scope of the present invention.

(First Embodiment)

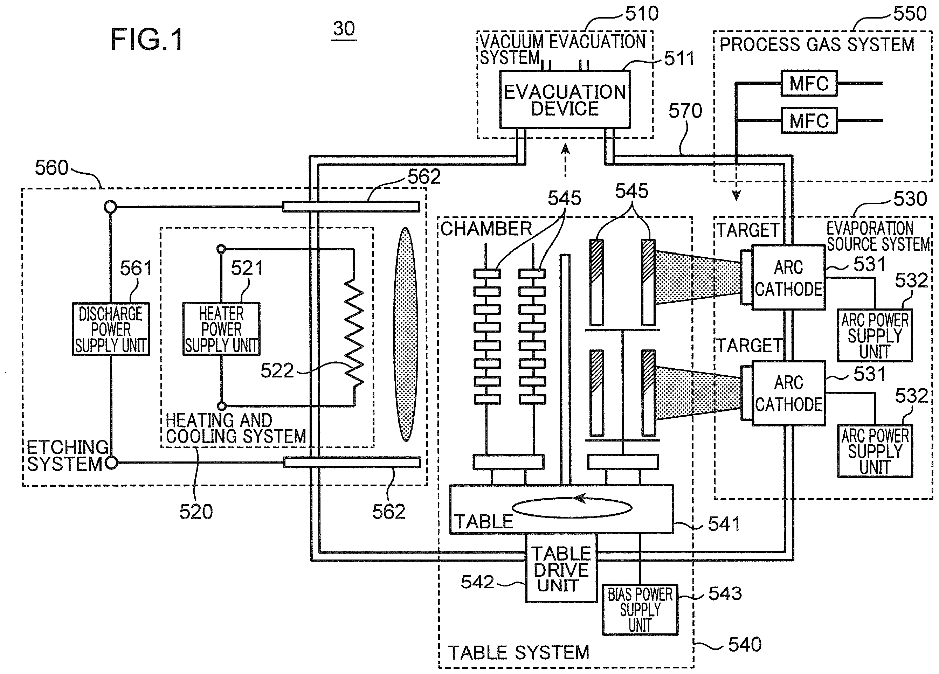

FIG. 1 is an overall configuration view of a film forming device applied to the machine learning system according to the first embodiment. A film forming device 30 is a device that forms a hard film on a workpiece (object to be coated) that is a base material of a cutting tool by an arc ion plating method. The arc ion plating method is a type of ion plating method for evaporating a solid material using vacuum arc discharge. The arc ion plating method is suitable for film formation of a cutting tool because the ionization rate of the evaporated material is high and a film excellent in adhesion can be formed. The hard film is, for example, TiN, TiAlN, TiCN, CrN, or the like.

The film forming device 30 includes a vacuum evacuation system 510, a heating and cooling system 520, an evaporation source system 530, a table system 540, a process gas system 550, an etching system 560, and a chamber 570.

The vacuum evacuation system 510 includes an evacuation device 511 and evacuates the inside of the chamber 570. The evacuation device 511 includes a pump or the like for evacuating air in the chamber 570.

The heating and cooling system 520 includes a heater power supply unit 521 and a heater 522, and heats a workpiece 545. The heater power supply unit 521 is a power supply circuit that supplies electric power to the heater 522. The heater 522 is provided in the chamber 570 and generates heat by electric power supplied from the heater power supply unit 521. The heating and cooling system 520 cools the workpiece 545 by stopping heat generation of the heater 522.

The evaporation source system 530 is a system that evaporates a target (film formation material). The evaporation source system 530 includes an arc cathode 531 and an arc power supply unit 532. The arc power supply unit 532 is a power supply circuit that supplies a discharge current to the arc cathode 531. The arc cathode 531 includes a target, and generates vacuum arc discharge with the inner wall of the chamber 570 by the electric power supplied from the arc power supply unit 532. When the vacuum arc discharge is started, a molten region called an arc spot having a diameter of several $\mu$m is generated on the cathode surface. A high-density current is concentrated in the arc spot, and the cathode surface is instantaneously molten and evaporated. This vacuum arc discharge forms a film on the surface of the workpiece 545.

In the example of FIG. 1, two pairs of the arc cathode 531 and the arc power supply unit 532 are illustrated, but this is an example, and the number of pairs of the arc cathode 531 and the arc power supply unit 532 may be one or three or more.

The table system 540 is a rotary table on which the workpiece 545 is mounted. The table system 540 includes a table 541, a table drive unit 542, and a bias power supply unit 543. The table 541 is provided in the chamber 570. The workpiece 545 is placed on the table 541. The table drive unit 542 includes a motor and the like, and rotates the table 541. The bias power supply unit 543 applies a negative potential to the workpiece 545 via the table 541.

The process gas system 550 introduces a process gas for forming a reactive film in the chamber 570.

The etching system 560 includes a discharge power supply unit 561, a pair of filament electrodes 562, and a filament (not illustrated) provided between the pair of filament electrodes 562. The discharge power supply unit 561 is a power supply circuit that supplies a discharge current to the filament via the pair of filament electrodes 562. The etching system 560 generates argon plasma between the arc cathode 531 and the filament and between the inner wall of the chamber 570 and the filament. The surface of the workpiece 545 is cleaned by this generation of the argon plasma. In this cleaning, the arc cathode 531 and the inner wall of the chamber 570 function as an anode, and the filament functions as a cathode.

The chamber 570 is a container that accommodates the workpiece 545. The inside of the chamber 570 is evacuated by the vacuum evacuation system 510 to maintain the vacuum state.

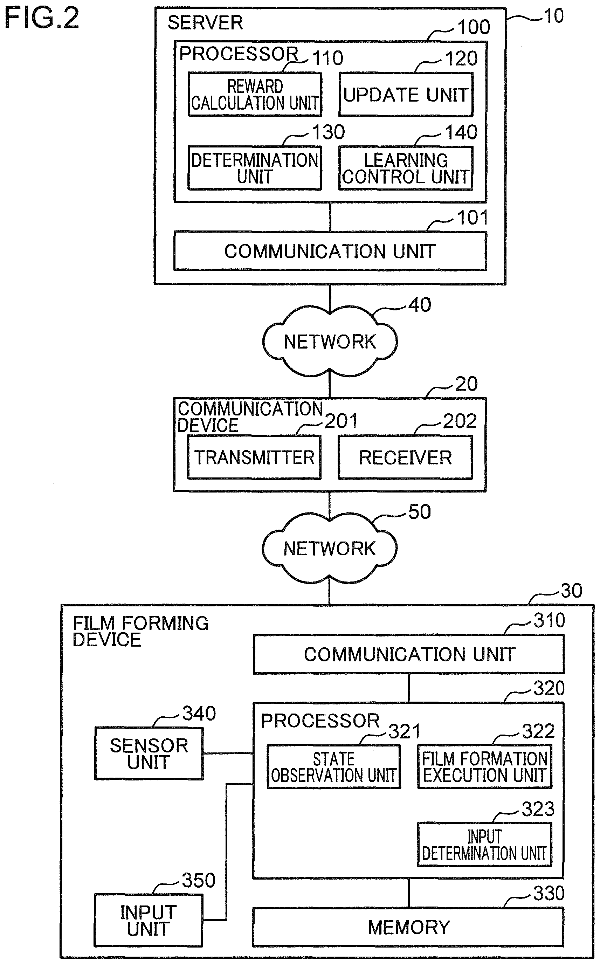

FIG. 2 is an overall configuration view of the machine learning system according to the first embodiment. The machine learning system includes a server 10, a communication device 20, and the film forming device 30. The server 10 and the communication device 20 are communicably connected to each other via a network 40. The communication device 20 and the film forming device 30 are communicably connected to each other via a network 50. The network 40 is a wide-area communication network such as the Internet. The network 50 is, for example, a local area network. The server 10 is, for example, a cloud server including one or more computers. The communication device 20 is, for example, a computer owned by a user who uses the film forming device 30. The communication device 20 functions as a gateway for connecting the film forming device 30 to the network 40. The communication device 20 is implemented by installing dedicated application software into a computer owned by the user. Alternatively, the communication device 20 may be a dedicated device provided to the user by a manufacturer of the film forming device 30. The film forming device 30 is the film forming device described with reference to FIG. 1.

The configuration of each device will be specifically described below. The server 10 includes a processor 100 and a communication unit 101. The processor 100 is a control device including a CPU and the like. The processor 100 includes a reward calculation unit 110, an update unit 120, a determination unit 130, and a learning control unit 140. Each block included in the processor 100 may be implemented by the processor 100 executing a machine learning program for causing a computer to function as the server 10 in the machine learning system, or may be implemented by a dedicated electric circuit.

The reward calculation unit 110 calculates a reward for a determination result of at least one film formation condition based on the state variable observed by a state observation unit 321.

Based on the reward calculated by the reward calculation unit 110, the update unit 120 updates a function for determining at least one film formation condition from the state variable observed by the state observation unit 321. As the function, an action value function described later is adopted.

The determination unit 130 determines at least one film formation condition under which the reward is obtained most by repeating update of the function.

The learning control unit 140 performs overall control of machine learning. The machine learning system of the present embodiment learns film formation conditions by reinforcement learning. The reinforcement learning is a machine learning method in which an agent (action subject) selects a certain action based on an environmental situation, the agent is caused to change the environment based on the selected action, and the agent is given a reward associated with the environmental change, whereby the agent is caused to learn selection of a better action. As the reinforcement learning, Q learning and TD learning can be adopted. In the following description, Q learning will be described as an example. In the present embodiment, the reward calculation unit 110, the update unit 120, the determination unit 130, the learning control unit 140, and the state observation unit 321 described later correspond to agents.

The communication unit 101 includes a communication circuit that connects the server 10 to the network 40. The communication unit 101 receives, via the communication device 20, the state variable observed by the state observation unit 321. The communication unit 101 transmits the film formation condition determined by the determination unit 130 to the film forming device 30 via the communication device 20. In the present embodiment, the communication unit 101 is an example of a state acquisition unit that acquires a state variable.

The communication device 20 includes a transmitter 201 and a receiver 202. The transmitter 201 transmits the state variable transmitted from the film forming device 30 to the server 10, and transmits the film formation condition transmitted from the server 10 to the film forming device 30. The receiver 202 receives the state variable transmitted from the film forming device 30 and receives the film formation condition transmitted from the server 10.

The film forming device 30 includes a communication unit 310, a processor 320, a memory 330, a sensor unit 340, and an input unit 350 in addition to the configuration shown in FIG. 1.

The communication unit 310 is a communication circuit for connecting the film forming device 30 to the network 50. The communication unit 310 transmits the state variable observed by the state observation unit 321 to the server 10. The communication unit 310 receives the film formation condition determined by the determination unit 130 of the server 10. The communication unit 310 receives a film formation execution command, which is described later, determined by the learning control unit 140.

The processor 320 is a control device including a CPU. The processor 320 includes the state observation unit 321, a film formation execution unit 322, and an input determination unit 323. The communication unit 310 transmits the state variable acquired by the state observation unit 321 to the server 10. Each block included in the processor 320 is implemented by, for example, the CPU executing a machine learning program causing each block included in the processor 320 to function as the film forming device 30 of the machine learning system.

The state observation unit 321 acquires the physical quantity detected by the sensor unit 340 after execution of film formation. The state observation unit 321 observes a state variable including at least one physical quantity related to performance evaluation of film formation after execution of film formation and at least one film formation condition.

Specifically, the state observation unit 321 acquires a film formation condition based on the measurement value of the sensor unit 340. The state observation unit 321 acquires a physical quantity based on the measurement value of the sensor unit 340 or the like.

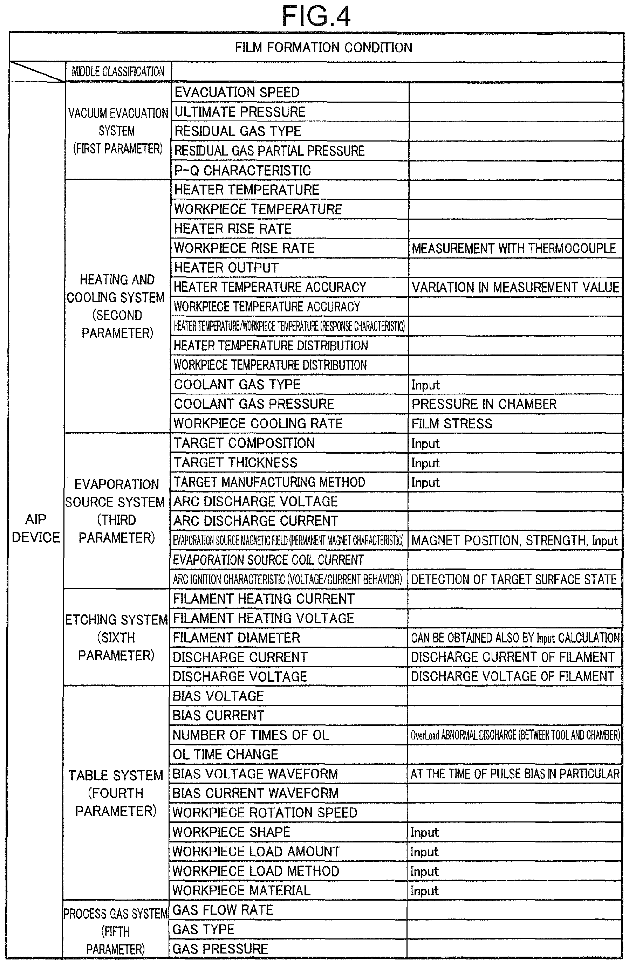

FIG. 4 is a view showing an example of the film formation condition. The film formation condition is roughly classified into the middle classification. The middle classification includes at least one parameter of a first parameter related to the vacuum evacuation system 510, a second parameter related to the heating and cooling system 520, a third parameter related to the evaporation source system 530, a fourth parameter related to the table system 540, and a fifth parameter related to the process gas system 550. Furthermore, the middle classification may include a sixth parameter related to the etching system 560.

The first parameter includes at least one of an evacuation speed, an ultimate pressure, a residual gas type, a residual gas partial pressure, and a P-Q characteristic. The evacuation speed is a speed at which the vacuum evacuation system 510 evacuates the air and residual gas in the chamber 570 and the introduced process gas. The evacuation speed is obtained by, for example, calculation from a performance value of a pump constituting the vacuum evacuation system 510. Alternatively, the evacuation speed may be a measurement value calculated from the pressure sensor and the evacuation time. The ultimate pressure is the pressure in the chamber 570 before start of film formation process. The ultimate pressure is obtained by, for example, calculation from a performance value of a pump constituting the vacuum evacuation system 510. Alternatively, the ultimate pressure may be a measurement value of the pressure sensor. The residual gas type is a gas residual in the chamber 570 and is an impurity. The residual gas type is, for example, nitrogen, oxygen, moisture, hydrogen, and the like. The residual gas type is determined based on the partial pressure of the residual gas described later. The residual gas partial pressure is a partial pressure of a plurality of residual gases residual in the chamber 570. The residual gas partial pressure is obtained by measurement of a vacuum residual gas monitor such as a quadrupole mass spectrometer. The P-Q characteristic is a characteristic indicating the relationship between the chamber internal pressure (P) and the flow rate (Q). The P-Q characteristic is obtained by calculation from, for example, the flow rate of the gas in the chamber 570 detected by the flow rate sensor and the measurement value of the pressure sensor.

The second parameter includes at least one of a heater temperature, a workpiece temperature, a heater temperature rise rate, a workpiece temperature rise rate, a heater output, a heater temperature accuracy, a workpiece temperature accuracy, a heater temperature/workpiece temperature, a heater temperature distribution, a workpiece temperature distribution, a coolant gas type, a coolant gas pressure, and a workpiece cooling rate.

The heater temperature is the temperature of the heater 522. The heater temperature is a measurement value of a temperature sensor (thermocouple), for example. The workpiece temperature is a temperature of the workpiece 545. The workpiece temperature is a measurement value of a temperature sensor provided in the vicinity of the workpiece 545, for example. The heater temperature rise rate is a change rate of the heater temperature when the heater 522 rises in temperature. The heater temperature rise rate is obtained from a time-series change in the heater temperature. The workpiece temperature rise temperature is a change rate of the workpiece temperature when the workpiece 545 rises in temperature. The workpiece temperature rise rate is obtained from a time-series change in the workpiece temperature.

The heater output is the output of the heater 522. The heater output is obtained by calculation from the setting value of the heater power supply unit 521. The heater output may be calculated from measurement values by the sensor of a current value and a voltage value supplied to the heater.

The heater temperature accuracy is a value indicating variation in heater temperature. The heater temperature accuracy is calculated from a measurement value of past heater temperature. The workpiece temperature accuracy is a value indicating variation in workpiece temperature. The workpiece temperature accuracy is calculated from a measurement value of past workpiece temperature. The heater temperature/workpiece temperature is a response characteristic of the heater 522 with respect to the workpiece 545.

The heater temperature distribution is a temperature distribution of the heater 522. The heater temperature distribution is obtained from measurement values of a plurality of temperature sensors provided around the heater 522. The workpiece temperature distribution is a temperature distribution of the workpiece 545. The workpiece temperature distribution is obtained from measurement values of a plurality of temperature sensors provided around the workpiece 545.

The coolant gas type is information indicating the type of gas for cooling the inside of the chamber 570, and is an input value input in advance. The coolant gas pressure is the pressure of the coolant gas. The coolant gas pressure is a measurement value by a pressure sensor provided in the chamber 570. The workpiece cooling rate is a cooling rate of the workpiece 545. The workpiece cooling rate is obtained from a time-series change in the workpiece temperature detected by a temperature sensor provided in the vicinity of the workpiece 545.

The third parameter includes at least one of a target composition, a target thickness, a target manufacturing method, an arc discharge voltage, an arc discharge current, an evaporation source magnetic field, an evaporation source coil current, and an arc ignition characteristic. The target composition is a composition of a substance constituting the target. The target thickness is the thickness of the target. The target manufacturing method is a manufacturing method of the target. The target composition, the target thickness, and the target manufacturing method are input values input in advance.

The arc discharge voltage is a voltage supplied from the arc power supply unit 532 to the arc cathode 531, and is a measurement value by the sensor. The arc discharge current is a current supplied from the arc power supply unit 532 to the arc cathode 531, and is a measurement value by the sensor.

The evaporation source magnetic field is the position and strength of the magnetic field emitted by the permanent magnetic flux contained in the evaporation source system 530. The evaporation source magnetic field is an input value input in advance. The evaporation source coil current is a current flowing through the coil included in the evaporation source system 530, and is a measurement value obtained by a sensor. The arc ignition characteristic is behavior of the voltage and current on the arc surface at the time of arc ignition. The arc ignition characteristic is obtained from measurement values of the arc discharge voltage and the arc discharge current at certain timing.

The fourth parameter includes at least one of a bias voltage, a bias current, the number of times of OL, an OL time change, a bias voltage waveform, a bias current waveform, a workpiece rotation speed, a workpiece shape, a workpiece load amount, a workpiece load method, and a workpiece material.

The bias voltage is a bias voltage supplied to the workpiece 545 by the bias power supply unit 543, and is a measurement value by the sensor. The bias current is a bias current supplied to the workpiece 545 by the bias power supply unit 543, and is a measurement value by the sensor.

The number of times of OL (Over Load) is the number of times of abnormal discharge in the table system or the workpiece, and is a measurement value by the sensor. The OL time change is the number of times of OL per unit time. The bias voltage waveform is a waveform of the bias voltage, and is obtained from a measurement value by the sensor. The bias voltage waveform is a voltage waveform at the time of pulse bias in particular. The bias current waveform is a waveform of the bias current, and is obtained from a measurement value by the sensor. The workpiece rotation speed is the rotation speed per unit time of the workpiece 545, and includes the rotation speed per unit time of the table 541 and the rotation speed per unit time when the workpiece 545 rotates on the table 541. The workpiece rotation speed is a detection value by the sensor, for example. The workpiece shape is a numerical value indicating the shape of the workpiece 545 and is an input value input in advance. The workpiece load amount is a load amount (e.g., weight) of the workpiece 545, and is an input value input in advance. The workpiece load method is a load method of the workpiece 545 with respect to the table 541, and is an input value input in advance. The workpiece material is a material of the workpiece 545, and is an input value input in advance.

The fifth parameter includes at least one of a gas flow rate, a gas type, and a gas pressure. The gas flow rate is a flow rate of the process gas. The gas type is information indicating the type of process gas. The gas pressure is the pressure of the process gas. These are detection values of sensors, for example.

The sixth parameter includes at least one of a filament heating current, a filament heating voltage, a filament diameter, a discharge current, and a discharge voltage. The filament heating current is a heating current for heating the pair of filament electrodes 562 constituting the etching system 560, and is a measurement value by the sensor. The filament heating voltage is a heating voltage for heating the pair of filament electrodes 562, and is a measurement value by the sensor.

The filament diameter is a diameter of each of the pair of filament electrodes 562, and is an input value input in advance. The filament diameter may be calculated by calculation. The discharge current is a discharge current of the pair of filament electrodes 562, and is a measurement value by the sensor. The discharge voltage is a discharge voltage of the pair of filament electrodes 562, and is a measurement value by the sensor.

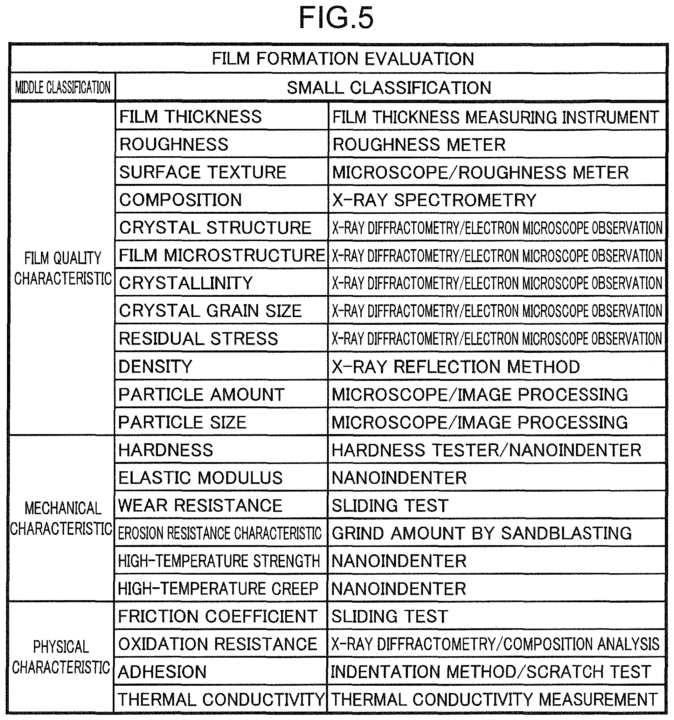

FIG. 5 is a view showing an example of a physical quantity according to the first embodiment. The physical quantity is roughly classified into the middle classification. The middle classification includes at least one of a film quality characteristic, a mechanical characteristic, and a physical characteristic. The film quality characteristic includes at least one of a film thickness, a roughness, a surface texture, a composition, a crystal structure, a film microstructure, crystallinity, a crystal grain size, a residual stress, a density, a particle amount, and a particle size.

The film thickness is the thickness of the film. The surface texture is a form of the surface including surface roughness. The composition is the composition of the film. The crystal structure is a crystal structure of the film. The film microstructure is in a general sense, and represents a microstructure such as a crystal form and orientation. The crystallinity is a proportion of crystal. The crystal grain size is the size of a crystal grain. The residual stress is an internal stress of the film.

The film thickness is obtained by a film thickness measuring instrument. The roughness is obtained by a roughness meter. The surface texture is obtained by a microscope or a roughness meter. The composition is obtained by X-ray spectrometry. The crystal structure, the film microstructure, the crystallinity, the crystal grain size, and the residual stress are obtained by X-ray diffractometry or an electron microscope.

The density is the density of the particles constituting the film. The particle amount is the amount of waste contained in the film. The particle size is the size of waste contained in the film. The density is obtained by an X-ray reflection method. The particle amount and the particle size are obtained by a microscope or image processing.

The mechanical characteristic includes at least one of hardness, elastic modulus, wear resistance, an erosion resistance characteristic, a high-temperature strength, and high-temperature creep. The hardness is obtained by a hardness tester or a nanoindenter. The elastic modulus is obtained by a nanoindenter. The wear resistance is obtained by a sliding test or a wear resistance test. The erosion resistance characteristic is a grind amount by sandblasting. The high-temperature strength and the high-temperature creep are obtained by a nanoindenter.

The physical characteristic includes at least one of a friction coefficient, oxidation resistance, adhesion, and thermal conductivity. The friction coefficient is obtained by a sliding test. The oxidation resistance is obtained by X-ray analysis or composition analysis. The adhesion is obtained by an indentation method or a scratch test. The thermal conductivity is obtained by thermal conductivity measurement.

Referring back to FIG. 2. The film formation execution unit 322 controls the film formation operation of the film forming device 30. The input determination unit 323 automatically or manually determines whether or not to be a mass production process. When automatically determining whether or not to be a mass production process, and when the number of times of input of a condition number input to the input unit 350 exceeds a reference number of times, the input determination unit 323 determines that the film forming device 30 is in the mass production process. The condition number is an identification number for specifying one certain film formation condition. The film formation condition specified by the condition number includes at least a film formation condition described as Input among the film formation conditions shown in FIG. 4.

In a case of manually determining whether or not to be a mass production process, when data indicating that it is a mass production process is input to the input unit 350, the input determination unit 323 determines that the film forming device 30 is in the mass production process. When in the mass production process, the film forming device 30 does not perform machine learning.

The memory 330 is, for example, a nonvolatile storage device, and stores a finally determined optimal film formation condition and the like. The sensor unit 340 is various sensors used for measurement of the film formation condition shown in FIG. 4 and the physical quantity shown in FIG. 5. The input unit 350 is an input device such as a keyboard and a mouse.

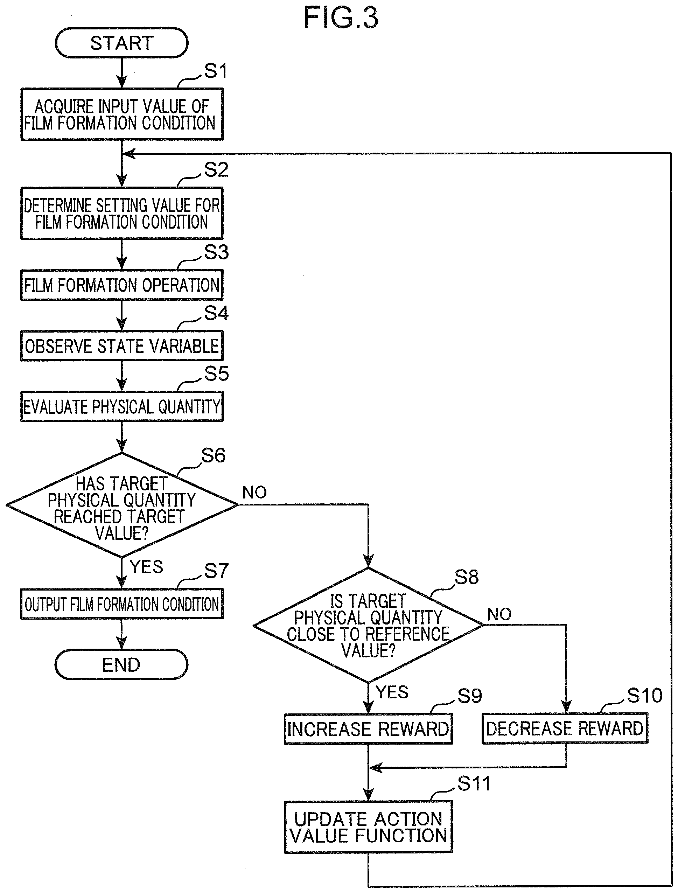

FIG. 3 is a flowchart showing an example of processing in the machine learning system shown in FIG. 2. In step S1, the learning control unit 140 acquires an input value of the film formation condition input by the user using the input unit 350. The input value acquired here is an input value for a film formation condition described as Input among the film formation conditions listed in FIG. 4.

In step S2, the learning control unit 140 determines at least one film formation condition and a setting value for the film formation condition. Here, the film formation condition to be set is a film formation condition other than the film formation condition described as Input among the film formation conditions listed in FIG. 4, and is at least one film formation condition for which the setting value can be set. Here, the setting value of the film formation condition to be determined corresponds to an action in reinforcement learning.

Specifically, the learning control unit 140 randomly selects a setting value for each film formation condition to be set. Here, the setting value is randomly selected from a predetermined range for each film formation condition.

In step S3, by transmitting a film formation execution command to the film forming device 30, the learning control unit 140 causes the film forming device 30 to start a film formation operation. When the film formation execution command is received by the communication unit 310, the film formation execution unit 322 sets the film formation condition in accordance with the film formation execution command and starts the film formation operation. The film formation execution command includes an input value of the film formation condition having been set in step S1 and a setting value of the film formation condition having been determined in step S2.

When the film formation operation ends, the state observation unit 321 observes the state variable (step S4). Specifically, the state observation unit 321 acquires, as state variables, a physical quantity related to the film formation evaluation described in FIG. 5 and a film formation condition under which the state is observed by a sensor or the like among the film formation conditions described in FIG. 4. The physical quantity may be input to the film forming device 30 by, for example, the user manipulating the input unit 350, or may be input to the film forming device 30 by a measuring instrument that measures the physical quantity and the film forming device 30 communicating with each other. The state observation unit 321 transmits the acquired state variable to the server 10 via the communication unit 310.

In step S5, the determination unit 130 evaluates the physical quantity. Here, the determination unit 130 evaluates the physical quantity by determining whether or not the physical quantity to be evaluated (hereinafter referred to as a target physical quantity) among the physical quantities acquired in step S4 has reached a predetermined reference value. The target physical quantity is one or a plurality of physical quantities among the physical quantities listed in FIG. 5. In a case where there are a plurality of target physical quantities, there are a plurality of reference values corresponding to the target physical quantities. As the reference value, for example, a predetermined value indicating that the film has reached a certain standard can be adopted.

When determining that the target physical quantity has reached the reference value (YES in step S6), the determination unit 130 outputs the film formation condition set in step S2 as a final film formation condition (step S7). On the other hand, when determining that the physical quantity has not reached the reference value (NO in step S6), the determination unit 130 proceeds with the processing to step S8. Note that in a case where there are a plurality of target physical quantities, the determination unit 130 is only required to determine YES in step S6 if all the target physical quantities have reached the reference value.

In step S8, the reward calculation unit 110 determines whether or not the target physical quantity is close to the reference value. If the target physical quantity is close to the reference value (YES in step S8), the reward calculation unit 110 increases the reward for the agent (step S9). On the other hand, if the target physical quantity is not close to the reference value (NO in step S8), the reward calculation unit 110 decreases the reward for the agent (step S10). In this case, the reward calculation unit 110 is only required to increase or decrease the reward in accordance with a predetermined increase or decrease value of the reward. Note that in a case where there are a plurality of target physical quantities, the reward calculation unit 110 is only required to perform the determination in step S8 for each of the plurality of target physical quantities. In this case, the reward calculation unit 110 is only required to increase or decrease the reward for each of the plurality of target physical quantities based on the determination result of step S8. In addition, a different value may be adopted as the increase or decrease value of the reward in accordance with the target physical quantity.

In step S11, the update unit 120 updates the action value function using the reward given to the agent. The Q-learning adopted in the present embodiment is a method of learning a Q-value ($Q(s,a)$) that is a value for selection of an action a under a certain environment state s. Note that an environment state $s_t$ corresponds to the state variable of the above flow. Then, in the Q-learning, an action a with the highest $Q(s,a)$ is selected in the certain environment state s. In the Q-learning, various actions a are taken under the certain environment state s by trial and error, and correct $Q(s,a)$ is learned using the reward at that time. An update expression of the action value function $Q(st,at)$ is expressed by the following expression (1).

[Expression 1]

$$Q(s_t, a_t) \leftarrow Q(s_t, a_t) + \alpha (r_{t+1} + \gamma \max_a Q(s_{t+1}, a) - Q(s_t, a_t))$$
$$\cdots (1)$$

Here, $s_t$ and at represent an environment state and an action at time t, respectively. The environment state changes to $s_{t+1}$ by the action at, and a reward $r_{t+1}$ is calculated by the change of the environment state. The term with max is a Q value ($Q(s_{t+1},a)$) in a case where the most valuable action a known at that time is selected under the environment state $s_{t+1}$, the Q value multiplied by $\gamma$. Here, $\gamma$ is a discount rate and has a value of $0 < \gamma \leq 1$ (normally 0.9 to 0.99). $\alpha$ is a learning coefficient and has a value of $0 < \alpha \leq 1$ (normally about 0.1).

In this update expression, if $\gamma \cdot \max Q(s_{t+1},a)$ based on the Q value when taking the best action in the next environment state $s_{t+1}$ by the action a is larger than Q $Q(st,at)$, which is the Q value of the action a in the state s, $Q(st, at)$ is made large. On the other hand, in this update expression, if $\gamma \cdot \max Q(s_{t+1},a)$ is smaller than $Q(st,at)$, $Q(s_t,a_t)$ is made small. That is, the value of the certain action a in the certain state $s_t$ is made close to the value of the best action in the next state $s_{t+1}$ by the action a. Due to this, an optimal state for forming a film on the workpiece 545, i.e., at least one optimal film formation condition is determined.

When the processing of step S11 ends, the processing returns to step S2, and the setting value of the selected film formation condition is changed, or an unselected film formation condition is selected as the next film formation condition, whereby the action value function is similarly updated. Although the update unit 120 updates the action value function, the present invention is not limited thereto, and the update unit 120 may update an action value table.

In $Q(s,a)$, values for all pairs of states and actions $(s,a)$ may be stored in a table format. Alternatively, $Q(s,a)$ may be expressed by an approximate function that approximates values for all the pairs of states and actions $(s,a)$. This approximation function may include a neural network having a multilayer structure. In this case, the neural network is only required to learn, in real time, data obtained by actually operating the film forming device 30 and perform online learning to reflect it in the next action. This achieves deep reinforcement learning.

Conventionally, in a film forming device, development of film formation condition has been performed by changing the film formation condition so as to give a good film. In order to obtain a good film, it is required to find the relationship between the evaluation of the film and the film formation condition. However, since the number of types of film formation conditions is enormous as shown in FIG. 4, an extremely large number of physical models are necessary to define such a relationship, and it has been found that it is difficult to describe such a relationship by a physical model. Furthermore, in order to construct such a physical model, it is also required to artificially find which parameter affects evaluation of which film, and this construction is difficult.

Thus, according to the first embodiment, at least one parameter among the first to sixth parameters described above and at least one physical quantity among a film quality characteristic, a mechanical characteristic, and a physical characteristic that are related to performance evaluation of film formation are observed as state variables. Then, the reward for the determination result of the film formation condition is calculated based on the observed state variable, the action value function for determining the film formation condition from the state variable is updated based on the calculated reward, and the film formation condition under which the reward is obtained most is learned by repeating this update. Thus, in the first embodiment, the film formation condition is determined by machine learning without using the above-described physical model. As a result, the first embodiment can easily determine an appropriate film formation condition for the cutting tool.

(Second Embodiment)

The film forming device 30 of the second embodiment is a device that forms a decorative film on a workpiece for the purpose of enhancing decorativeness. The workpiece is, for example, a decorative article such as a wristwatch and a necklace, a housing of a mobile phone, a bumper of an automobile, and the like. The decorative film is, for example, TiN, TiAlN, TiCN, CrN, diamond-like carbon (DLC), or the like. The machine learning system of the second embodiment performs machine learning of an appropriate film formation condition related to a decorative film.

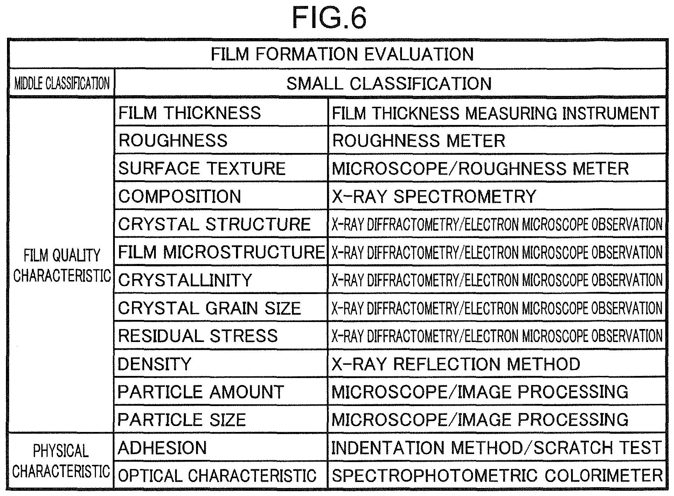

Note that in the second embodiment, the same components as those in the first embodiment are given identical reference numerals, and description thereof will be omitted. In the second embodiment, the configuration of the film forming device 30 is the same as that in FIG. 2, the processing of the film forming device 30 is the same as that in FIG. 3, and an example of the film formation condition is the same as that in FIG. 4. A large difference in the second embodiment from the first embodiment lies in physical quantity. FIG. 6 is a view showing an example of the physical quantity according to the second embodiment.

The physical quantity is roughly classified into the middle classification. The middle classification includes at least one of a film quality characteristic and a physical characteristic.

The film quality characteristic is the same as that in the first embodiment. The physical characteristic includes at least one of adhesion and an optical characteristic. The adhesion indicates the degree of adhesion of the film to the base material, and is obtained by an indentation method or a scratch test. The optical characteristic indicates the color, luster, or texture of the film. The optical characteristic is measured by a spectrophotometric colorimeter.

Thus, according to the second embodiment, at least one parameter among the first to sixth parameters described above and at least one physical quantity of a film quality characteristic and a physical characteristic that are related to performance evaluation of film formation are observed as state variables. Then, the reward for the determination result of the film formation condition is calculated based on the observed state variable, the action value function for determining the film formation condition from the state variable is updated based on the calculated reward, and the film formation condition under which the reward is obtained most is learned by repeating this update. Therefore, in the second embodiment, the film formation condition is determined by machine learning without using the above-described physical model. As a result, the second embodiment can easily determine an appropriate film formation condition for the decorative film.

(Third Embodiment)

The film forming device 30 of the third embodiment is a device that forms a protective film for protection on a workpiece. The workpiece is, for example, a cutting tool, a mold for injection formation, a screw, and the like. The protective film is, for example, TiN, TiAlN, TiCN, CrN, or the like. The machine learning system of the third embodiment performs machine learning of an appropriate film formation condition related to a protective film.

Note that in the third embodiment, the same components as those in the first embodiment are given identical reference numerals, and description thereof will be omitted. In the third embodiment, the configuration of the film forming device 30 is the same as that in FIG. 2, the processing of the film forming device 30 is the same as that in FIG. 3, and an example of the film formation condition is the same as that in FIG. 4. A large difference in the third embodiment from the first embodiment lies in physical quantity.

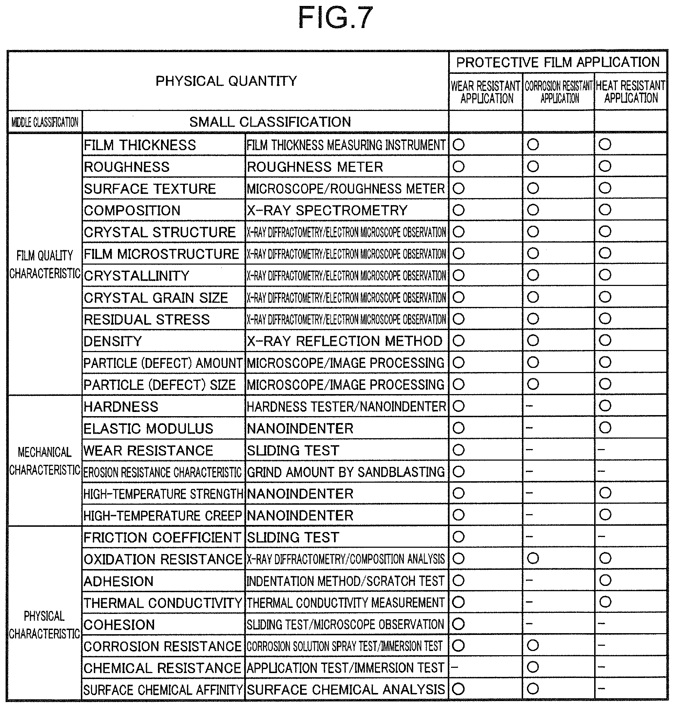

FIG. 7 is a view showing an example of the physical quantity according to the third embodiment. The physical quantity is roughly classified into the middle classification. The middle classification includes at least one of a film quality characteristic, a mechanical characteristic, and a physical characteristic. The film quality characteristic and the mechanical characteristic are the same as those in the first embodiment.

The physical characteristic includes at least one of a friction coefficient, oxidation resistance, adhesion, thermal conductivity, cohesion, corrosion resistance, chemical resistance, and surface chemical affinity. The friction coefficient is obtained by a sliding test. The oxidation resistance is obtained by X-ray diffractometry or composition analysis. The adhesion indicates the degree of adhesion of the film to the base material, and is obtained by an indentation method or a scratch test. The thermal conductivity is obtained by thermal conductivity measurement. The cohesion is obtained by a sliding test or microscopic observation. The corrosion resistance indicates difficulty in corrosion of the film, and is obtained by a corrosion solution spray test or an immersion test. The chemical resistance indicates difficulty in corrosion of the film due to chemicals, and is obtained by an application test or an immersion test. The surface chemical affinity indicates chemical affinity between the film surface and an external environmental substance, and is obtained by surface chemical analysis.

The physical quantity shown in FIG. 7 varies depending on the application of the protective film. In FIG. 7, a circle mark indicates a physical quantity required for each of wear resistant applications, corrosion resistant applications, and heat resistant applications.

For example, in the film quality characteristic, the physical quantity required for each of wear resistant applications, corrosion resistant applications, and heat resistant applications are the same.

Regarding the wear resistant applications, for example, for the mechanical characteristic, at least one physical quantity is required among all the physical quantities listed in FIG. 7, and for the physical characteristic, at least one physical quantity is required among a friction coefficient, oxidation resistance, adhesion, thermal conductivity, cohesion, corrosion resistance, and surface chemical affinity.

Regarding the corrosion resistant applications, the mechanical characteristic may be omitted, and for the physical characteristic, a physical quantity of at least one of oxidation resistance, corrosion resistance, chemical resistance, and surface chemical affinity is required. The hyphens in the table of FIG. 7 do not mean to actively exclude corresponding physical quantities, but mean that corresponding physical quantities may be included.

Regarding the heat resistant applications, for the mechanical characteristic, at least one physical quantity is required among hardness, elastic modulus, high-temperature strength, and high-temperature creep, and for the physical characteristic, at least one physical quantity is required among oxidation resistance, adhesion, and thermal conductivity.

Thus, according to the third embodiment, at least one parameter among the first to sixth parameters described above and at least one physical quantity of a film quality characteristic and a physical characteristic that are related to performance evaluation of film formation are observed as state variables. Then, the reward for the determination result of the film formation condition is calculated based on the observed state variable, the action value function for determining the film formation condition from the state variable is updated based on the calculated reward, and the film formation condition under which the reward is obtained most is learned by repeating this update. Therefore, in the third embodiment, the film formation condition is determined by machine learning without using the above-described physical model. As a result, the third embodiment can easily determine an appropriate film formation condition for the protective film.

(Fourth Embodiment)

The film forming device 30 of the fourth embodiment is a device that forms a sliding film on the surface of a workpiece in order to improve hardness of the workpiece surface. The workpiece is, for example, a sliding component of an engine, a piston, and the like. The sliding film is, for example, TiN, TiAlN, TiCN, CrN, diamond-like carbon (DLC), or the like. The machine learning system of the fourth embodiment performs machine learning of an appropriate film formation condition related to a sliding film.

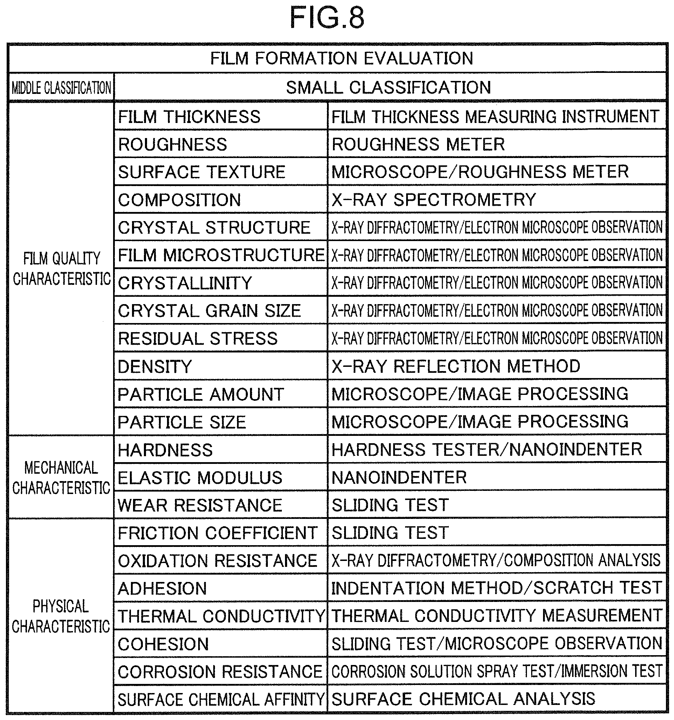

Note that in the fourth embodiment, the same components as those in the first embodiment are given identical reference numerals, and description thereof will be omitted. In the fourth embodiment, the configuration of the film forming device 30 is the same as that in FIG. 2, the processing of the film forming device 30 is the same as that in FIG. 3, and an example of the film formation condition is the same as that in FIG. 4. A large difference in the fourth embodiment from the first embodiment lies in physical quantity. FIG. 8 is a view showing an example of the physical quantity according to the fourth embodiment. The physical quantity is roughly classified into the middle classification. The middle classification includes at least one of a film quality characteristic, a mechanical characteristic, and a physical characteristic. The film quality characteristic is the same as that in the first embodiment.

The mechanical characteristic includes at least one of hardness, elastic modulus, and wear resistance. The hardness is obtained by a hardness tester or a nanoindenter. The elastic modulus is obtained by a nanoindenter. The wear resistance is obtained by a sliding test or a wear resistance test.

The physical characteristic includes at least one of a friction coefficient, oxidation resistance, adhesion, thermal conductivity, cohesion, corrosion resistance, and surface chemical affinity. The friction coefficient is obtained by a sliding test. The oxidation resistance is obtained by X-ray analysis or composition analysis. The adhesion indicates the degree of adhesion of the film to the base material, and is obtained by an indentation method or a scratch test. The thermal conductivity is obtained by thermal conductivity measurement. The cohesion is obtained by a sliding test or microscopic observation. The corrosion resistance indicates difficulty in corrosion of the film, and is obtained by a corrosion solution spray test or an immersion test. The surface chemical affinity indicates chemical affinity between an external environmental substance and the film surface, and is obtained by surface chemical analysis.

Thus, according to the fourth embodiment, at least one parameter among the first to sixth parameters described above and at least one physical quantity among a film quality characteristic, a mechanical characteristic, and a physical characteristic that are related to performance evaluation of film formation are observed as state variables. Then, the reward for the determination result of the film formation condition is calculated based on the observed state variable, the action value function for determining the film formation condition from the state variable is updated based on the calculated reward, and the film formation condition under which the reward is obtained most is learned by repeating this update. Therefore, in the fourth embodiment, the film formation condition is determined by machine learning without using the above-described physical model. As a result, the present embodiment can easily determine an appropriate film formation condition for the sliding film.

Note that the present invention can adopt the following modification.

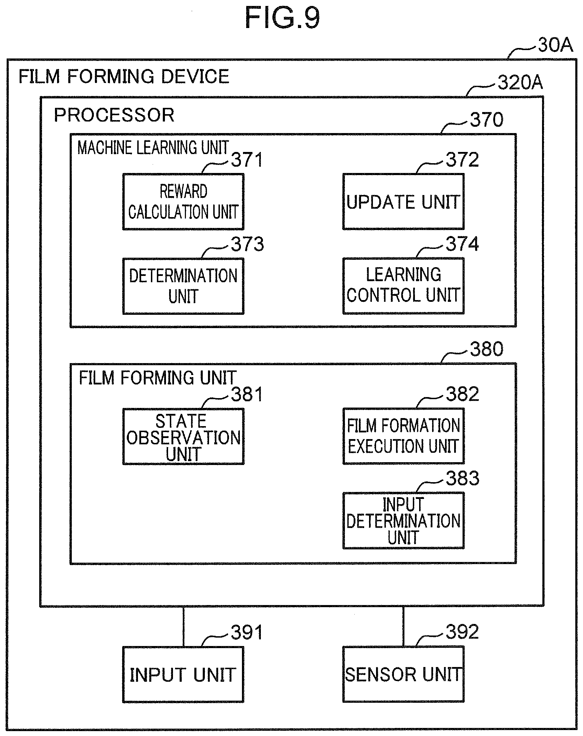

(1) FIG. 9 is an overall configuration view of the machine learning system according to a modification of the present invention. The machine learning system according to this modification includes a film forming device 30A alone. The film forming device 30A includes a processor 320A, an input unit 391, and a sensor unit 392. The processor 320A includes a machine learning unit 370 and a film forming unit 380. The machine learning unit 370 includes a reward calculation unit 371, an update unit 372, a determination unit 373, and a learning control unit 374. The reward calculation unit 371 to the learning control unit 374 are the same as the reward calculation unit 110 to the learning control unit 140, respectively, shown in FIG. 2. A state observation unit 381, a film formation execution unit 382, and an input determination unit 383 are the same as the state observation unit 321, the film formation execution unit 322, and the input determination unit 323, respectively, shown in FIG. 2. The input unit 391 and the sensor unit 392 are the same as the input unit 350 and the sensor unit 340, respectively, shown in FIG. 2. In the present modification, the state observation unit 381 is an example of a state acquisition unit that acquires state information.

Thus, according to the machine learning system according to this modification, the optimal film formation condition can be learned by the film forming device 30A alone.

(2) In the above flow, the state variable is observed after the end of the film formation operation, but this is an example and a plurality of state variables may be observed during one film formation operation. For example, when the state variable only includes an instantaneously measurable parameter, a plurality of state variables can be observed during one film formation operation. This shortens learning time.

(3) In the first to fourth embodiments described above, the film forming device 30 is a device that forms a film by the arc ion plating method, but the present invention is not limited thereto, and may be a device that forms a film by another physical vapor deposition such as an evaporation method.

The present embodiment is summarized as follows.

A machine learning method according to one aspect of the present invention is a machine learning method in which a machine learning device determines a film formation condition of a film forming device that forms a film on a workpiece that is a base material, the film forming device including a vacuum evacuation system that evacuates a chamber, a heating and cooling system that heats and cools the chamber, an evaporation source system that evaporates a target, a table system on which a workpiece is placed, a process gas system that introduces a process gas into the chamber, and an etching system, the machine learning method including: acquiring a state variable including at least one physical quantity related to performance evaluation of film formation and at least one film formation condition; calculating a reward for a determination result of the at least one film formation condition based on the state variable; updating, based on the reward, a function for determining the at least one film formation condition from the state variable; and determining a film formation condition under which the reward is obtained most by repeating update of the function, in which the at least one film formation condition is at least one of a first parameter related to the vacuum evacuation system, a second parameter related to the heating and cooling system, a third parameter related to the evaporation source system, a fourth parameter related to the table system, and a fifth parameter related to the process gas system, and the at least one physical quantity is at least one of a film quality characteristic, a mechanical characteristic, and a physical characteristic that are related to the film.

According to the present configuration, at least one film formation condition among the first parameter related to the vacuum evacuation system, the second parameter related to the heating and cooling system, the third parameter related to the evaporation source system, the fourth parameter related to the table system, and the fifth parameter related to the process gas system, and at least one physical quantity among a film quality characteristic, a mechanical characteristic, and a physical characteristic that are related to performance evaluation of film formation are observed as state variables. Then, the reward for the determination result of the film formation condition is calculated based on the observed state variable, the function for determining the film formation condition from the state variable is updated based on the calculated reward, and the film formation condition under which the reward is obtained most is learned by repeating this update. Therefore, the present configuration can easily determine an appropriate film formation condition for the base material.

In the above configuration, the first parameter may be at least one of an evacuation speed, an ultimate pressure, a residual gas type, a residual gas partial pressure, and a P-Q characteristic.

According to the present configuration, since machine learning is performed with at least one of the evacuation speed, the ultimate pressure, the residual gas type, the residual gas partial pressure, and the P-Q characteristic as the film formation condition related to the vacuum evacuation system, an appropriate film formation condition can be determined in consideration of the state of the vacuum evacuation system.

In the above configuration, the second parameter may be at least one of a heater temperature of a heater that constitutes the heating and cooling system, a workpiece temperature that is a temperature of the workpiece, a temperature rise rate of the heater, a temperature rise rate of the workpiece, an output of the heater, a temperature accuracy of the heater, a temperature accuracy of the workpiece, response characteristics of the heater temperature and the workpiece temperature, a temperature distribution of the heater, and a temperature distribution of the workpiece.

According to the present configuration, since machine learning is performed with at least one of the heater temperature, the workpiece temperature, the temperature rise rate of the heater, the temperature rise rate of the workpiece, the output of the heater, the temperature accuracy of the heater, the temperature accuracy of the workpiece, the response characteristic of the heater temperature, the response characteristic of the workpiece temperature, the temperature distribution of the heater, and the temperature distribution of the workpiece as the film formation condition related to the heating and cooling system, an appropriate film formation condition can be determined in consideration of the state of the heating and cooling system.

In the above configuration, the third parameter may be at least one of a composition of the target, a thickness of the target, a manufacturing method of the target, an arc discharge voltage, an arc discharge current, an evaporation source magnetic field, an evaporation source coil current, and an arc ignition characteristic.

According to the present configuration, since machine learning is performed with at least one of the composition of the target, the thickness of the target, the manufacturing method of the target, the arc discharge voltage, the arc discharge current, the evaporation source magnetic field, the evaporation source coil current, and the arc ignition characteristic as the film formation condition related to the evaporation source system, an appropriate film formation condition can be determined in consideration of the state of the evaporation source system.

In the above configuration, the fourth parameter may be at least one of a bias voltage with respect to the workpiece, a bias current with respect to the workpiece, the number of times of abnormal discharge, a time change of the abnormal discharge, a waveform of the bias voltage, a waveform of the bias current, a rotation speed of the workpiece, a shape of the workpiece, a load amount of the workpiece, a load method of the workpiece, and a material of the workpiece.

According to the present configuration, since machine learning is performed with at least one of the bias voltage, the bias current, the number of times of abnormal discharge, the time change of abnormal discharge, the waveform of the bias voltage, the waveform of the bias current, the rotational speed of the workpiece, the shape of the workpiece, the load amount of the workpiece, the load method of the workpiece, and the material of the workpiece as the film formation condition related to the table system, an appropriate film formation condition can be determined in consideration of the state of the table system.

In the above configuration, the fifth parameter may be at least one of a flow rate of the process gas, a type of the process gas, and a pressure of the process gas.

According to the present configuration, since machine learning is performed with at least one of the flow rate of the process gas, the type of the process gas, and the pressure of the process gas as the film formation condition related to the process gas system, an appropriate film formation condition can be determined in consideration of the state of the process gas system.

In the above configuration, the at least one film formation condition may further include a sixth parameter related to the etching system.

According to the present configuration, since machine learning is performed in consideration of the film formation condition related to the etching system, an appropriate film formation condition can be determined in consideration of the state of the etching system.

In the above configuration, the sixth parameter may be at least one of a heating current for heating a filament of the etching system, a heating voltage for heating the filament, a diameter of the filament, a discharge current of the filament, and a discharge voltage of the filament.

According to the present configuration, since machine learning is performed with at least one of the heating current of the filament, the heating voltage of the filament, the diameter of the filament, the discharge current of the filament, and the discharge voltage of the filament as the film formation condition related to the etching system, an appropriate film formation condition can be determined in consideration of the state of the etching system.

In the above configuration, a film for the base material may be any one of a film for a cutting tool that is the base material, a decorative film for decorating the base material, a protective film for protecting the base material, and a sliding film for improving hardness of a sliding member that is the base material.

According to the present configuration, it is possible to determine any one of an appropriate film formation condition of the film for the cutting tool, an appropriate film formation condition of the decorative film, an appropriate film formation condition of the protective film, and an appropriate film formation condition of the sliding film.

In the above configuration, the function may be updated in real time using deep reinforcement learning.

According to this configuration, since the function is updated in real time using the deep reinforcement learning, the function can be updated accurately and quickly.

Each processing of the machine learning method described above may be implemented by a machine learning device, or may be implemented and distributed in a machine learning program. The machine learning device may include a server or may include a film forming device.

A communication method according to another aspect of the present invention is a communication method for a film forming device when machine learning a film formation condition of the film forming device that forms a workpiece that is a base material, the film forming device including a vacuum evacuation system that evacuates a chamber, a heating and cooling system that heats and cools the chamber, an evaporation source system that evaporates a target, a table system on which a workpiece is placed, a process gas system that introduces a process gas into the chamber, an etching system, and a communication unit, the communication method including: observing a state variable including at least one physical quantity related to performance evaluation of film formation after film formation is executed and at least one film formation condition; and transmitting the state variable to a network via the communication unit and receiving at least one machine-learned film formation condition, in which the at least one film formation condition is at least one of a first parameter related to the vacuum evacuation system, a second parameter related to the heating and cooling system, a third parameter related to the evaporation source system, a fourth parameter related to the table system, and a fifth parameter related to the process gas system, and the at least one physical quantity is at least one of a film quality characteristic, a mechanical characteristic, and a physical characteristic that are related to the film.

According to the present configuration, information necessary for machine learning of film formation information is provided. Such a communication method can also be implemented in a film forming device.

**Claims**

1. A machine learning method in which a machine learning device determines a film formation condition of a film forming device that forms a film on a workpiece that is a base material,

   the film forming device including a vacuum evacuation system that evacuates a chamber, a heating and cooling system that heats and cools the chamber, an evaporation source system that evaporates a target, a table system on which a workpiece is placed, a process gas system that introduces a process gas into the chamber, and an etching system,
   the machine learning method comprising:

   acquiring a state variable including at least one physical quantity related to performance evaluation of film formation and at least one film formation condition;
   calculating a reward for a determination result of the at least one film formation condition based on the state variable;
   updating, based on the reward, a function for determining the at least one film formation condition from the state variable; and
   determining a film formation condition under which the reward is obtained most by repeating update of the function,
   wherein the at least one film formation condition is at least one of a first parameter related to the vacuum evacuation system, a second parameter related to the heating and cooling system, a third parameter related to the evaporation source system, a fourth parameter related to the table system, and a fifth parameter related to the process gas system, and
   the at least one physical quantity is at least one of a film quality characteristic, a mechanical characteristic, and a physical characteristic that are related to the film.

2. The machine learning method according to claim 1, wherein the first parameter is at least one of an evacuation speed, an ultimate pressure, a residual gas type, a residual gas partial pressure, and a P-Q characteristic.

3. The machine learning method according to claim 1, wherein the second parameter is at least one of a heater temperature of a heater that constitutes the heating and cooling system, a workpiece temperature that is a temperature of the workpiece, a temperature rise rate of the heater, a temperature rise rate of the workpiece, an output of the heater, a temperature accuracy of the heater, a temperature accuracy of the workpiece, response characteristics of the heater temperature and the workpiece temperature, a temperature distribution of the heater, and a temperature distribution of the workpiece.

4. The machine learning method according to claim 1, wherein the third parameter is at least one of a composition of the target, a thickness of the target, a manufacturing method of the target, an arc discharge voltage, an arc discharge current, an evaporation source magnetic field, an evaporation source coil current, and an arc ignition characteristic.

5. The machine learning method according to claim 1, wherein the fourth parameter is at least one of a bias voltage with respect to the workpiece, a bias current with respect to the workpiece, a number of times of abnormal discharge, a time change of the abnormal discharge, a waveform of the bias voltage, a waveform of the bias current, a rotation speed of the workpiece, a shape of the workpiece, a load amount of the workpiece, a load method of the workpiece, and a material of the workpiece.

6. The machine learning method according to claim 1, wherein the fifth parameter is at least one of a flow rate of the process gas, a type of the process gas, and a pressure of the process gas.

7. The machine learning method according to claim 1, wherein the at least one film formation condition further includes a sixth parameter related to the etching system.

8. The machine learning method according to claim 7, wherein the sixth parameter is at least one of a heating current for heating a filament of the etching system, a heating voltage for heating the filament, a diameter of the filament, a discharge current of the filament, and a discharge voltage of the filament.

9. The machine learning method according to claim 1, wherein a film for the base material is any one of a film for a cutting tool that is the base material, a decorative film for decorating the base material, a protective film for protecting the base material, and a sliding film for improving hardness of a sliding member that is the base material.

10. The machine learning method according to any of claims 1 to 9, wherein the function is updated in real time using deep reinforcement learning.

11. A machine learning device that determines a film formation condition of a film forming device that forms a film on a workpiece that is a base material,

the film forming device including a vacuum evacuation system that evacuates a chamber, a heating and cooling system that heats and cools the chamber, an evaporation source system that evaporates a target, a table system on which a workpiece is placed, a process gas system that introduces a process gas into the chamber, and an etching system,
the machine learning device comprising:

a state acquisition unit that acquires a state variable including at least one physical quantity related to performance evaluation of film formation and at least one film formation condition;
a reward calculation unit that calculates a reward for a determination result of the at least one film formation condition based on the state variable;
an update unit that updates, based on the reward, a function for determining the at least one film formation condition based on the state variable; and
a determination unit that determines a film formation condition under which the reward is obtained most by repeating update of the function,
wherein the at least one film formation condition is at least one of a first parameter related to the vacuum evacuation system, a second parameter related to the heating and cooling system, a third parameter related to the evaporation source system, a fourth parameter related to the table system, and a fifth parameter related to the process gas system, and
the at least one physical quantity is at least one of a film quality characteristic, a mechanical characteristic, and a physical characteristic that are related to the film.

12. A computer-readable machine learning program that causes a computer to function as a machine learning device that determines a film formation condition of a film forming device that forms a workpiece that is a base material,

the film forming device including a vacuum evacuation system that evacuates a chamber, a heating and cooling system that heats and cools the chamber, an evaporation source system that evaporates a target, a table system on which a workpiece is placed, a process gas system that introduces a process gas into the chamber, and an etching system,
the machine learning program causing a computer to function as:

a state acquisition unit that acquires a state variable including at least one physical quantity related to performance evaluation of film formation and at least one film formation condition;

a reward calculation unit that calculates a reward for a determination result of the at least one film formation condition based on the state variable;

an update unit that updates, based on the reward, a function for determining the at least one film formation condition based on the state variable; and

a determination unit that determines a film formation condition under which the reward is obtained most by repeating update of the function,

wherein the at least one film formation condition is at least one of a first parameter related to the vacuum evacuation system, a second parameter related to the heating and cooling system, a third parameter related to the evaporation source system, a fourth parameter related to the table system, and a fifth parameter related to the process gas system, and

the at least one physical quantity is at least one of a film quality characteristic, a mechanical characteristic, and a physical characteristic that are related to the film.

13. A communication method for a film forming device when machine learning a film formation condition of the film forming device that forms a workpiece that is a base material,

the film forming device including a vacuum evacuation system that evacuates a chamber, a heating and cooling system that heats and cools the chamber, an evaporation source system that evaporates a target, a table system on which a workpiece is placed, a process gas system that introduces a process gas into the chamber, an etching system, and a communication unit,

the communication method comprising:

observing a state variable including at least one physical quantity related to performance evaluation of film formation after film formation is executed and at least one film formation condition;

transmitting the state variable to a network via the communication unit and receiving at least one machine-learned film formation condition,

wherein the at least one film formation condition is at least one of a first parameter related to the vacuum evacuation system, a second parameter related to the heating and cooling system, a third parameter related to the evaporation source system, a fourth parameter related to the table system, and a fifth parameter related to the process gas system, and

the at least one physical quantity is at least one of a film quality characteristic, a mechanical characteristic, and a physical characteristic that are related to the film.

14. A film forming device that forms a film on a workpiece that is a base material, the film forming device comprising:

a vacuum evacuation system that evacuates a chamber;

a heating and cooling system that heats and cools the chamber;

an evaporation source system that evaporates a target;

a table system on which a workpiece is placed;

a process gas system that introduces a process gas into the chamber;

an etching system;

a state observation unit that observes a state variable including at least one physical quantity related to performance evaluation of film formation after film formation is executed and at least one film formation condition; and

a communication unit that transmits the state variable to a network and receives at least one machine-learned film formation condition,

wherein the at least one film formation condition is at least one of a first parameter related to the vacuum evacuation system, a second parameter related to the heating and cooling system, a third parameter related to the evaporation source system, a fourth parameter related to the table system, and a fifth parameter related to the process gas system, and

the at least one physical quantity is at least one of a film quality characteristic, a mechanical characteristic, and a physical characteristic that are related to the film.

FIG.1

30

510 VACUUM EVACUATION SYSTEM
511 EVACUATION DEVICE
550 PROCESS GAS SYSTEM
MFC
MFC
570
560 ETCHING SYSTEM
562
561 DISCHARGE POWER SUPPLY UNIT
520 HEATING AND COOLING SYSTEM
521 HEATER POWER SUPPLY UNIT
522
562
CHAMBER
545
545
530 EVAPORATION SOURCE SYSTEM
TARGET
ARC CATHODE 531
532 ARC POWER SUPPLY UNIT
TARGET
ARC CATHODE 531
532 ARC POWER SUPPLY UNIT
TABLE 541
542 TABLE DRIVE UNIT
543 BIAS POWER SUPPLY UNIT
540 TABLE SYSTEM

EP 3 978 644 A1

17

FIG.2

**SERVER** 10

**PROCESSOR** 100 110

REWARD CALCULATION UNIT

UPDATE UNIT 120

DETERMINATION UNIT 130

LEARNING CONTROL UNIT 140

COMMUNICATION UNIT 101

NETWORK 40

**COMMUNICATION DEVICE** 20

TRANSMITTER 201

RECEIVER 202

NETWORK 50

**FILM FORMING DEVICE** 30

COMMUNICATION UNIT 310

**PROCESSOR** 320

SENSOR UNIT 340

STATE OBSERVATION UNIT 321

FILM FORMATION EXECUTION UNIT 322

INPUT DETERMINATION UNIT 323

INPUT UNIT 350

MEMORY 330

# FIG.3

```
            ┌─────────────┐
            │    START    │
            └──────┬──────┘
                   │  ╭S1
        ┌──────────▼──────────┐
        │  ACQUIRE INPUT VALUE OF │
        │ FILM FORMATION CONDITION │
        └──────────┬──────────┘
                   │  ╭S2
        ┌──────────▼──────────┐
        │ DETERMINE SETTING VALUE FOR │
        │   FILM FORMATION CONDITION  │
        └──────────┬──────────┘
                   │  ╭S3
        ┌──────────▼──────────┐
        │  FILM FORMATION OPERATION │
        └──────────┬──────────┘
                   │  ╭S4
        ┌──────────▼──────────┐
        │  OBSERVE STATE VARIABLE │
        └──────────┬──────────┘
                   │  ╭S5
        ┌──────────▼──────────┐
        │ EVALUATE PHYSICAL QUANTITY │
        └──────────┬──────────┘
                   │  ╭S6
              ◇ HAS TARGET ◇  NO
              ◇ PHYSICAL QUANTITY ◇──────┐
              ◇ REACHED TARGET ◇         │
              ◇   VALUE?    ◇            │
                   │ YES                 │
                   │  ╭S7                │
        ┌──────────▼──────────┐         │
        │ OUTPUT FILM FORMATION CONDITION │   │
        └──────────┬──────────┘         │
                   │                     │  ╭S8
            ┌──────▼──────┐         ◇ IS TARGET ◇  NO
            │     END     │         ◇ PHYSICAL QUANTITY ◇──────┐
            └─────────────┘         ◇ CLOSE TO REFERENCE ◇     │
                                    ◇    VALUE?   ◇            │
                                         │ YES   ╭S9           │  ╭S10
                              ┌──────────▼──────────┐  ┌───────▼───────┐
                              │  INCREASE REWARD  │  │ DECREASE REWARD │
                              └──────────┬──────────┘  └───────┬───────┘
                                         │◄────────────────────┘
                                         │  ╭S11
                              ┌──────────▼──────────┐
                              │   UPDATE ACTION   │
                              │  VALUE FUNCTION   │
                              └──────────┬──────────┘
```

# FIG.4

| | MIDDLE CLASSIFICATION | FILM FORMATION CONDITION | |
|---|---|---|---|
| AIP DEVICE | VACUUM EVACUATION SYSTEM (FIRST PARAMETER) | EVACUATION SPEED | |
| | | ULTIMATE PRESSURE | |
| | | RESIDUAL GAS TYPE | |
| | | RESIDUAL GAS PARTIAL PRESSURE | |
| | | P-Q CHARACTERISTIC | |
| | HEATING AND COOLING SYSTEM (SECOND PARAMETER) | HEATER TEMPERATURE | |
| | | WORKPIECE TEMPERATURE | |
| | | HEATER RISE RATE | |
| | | WORKPIECE RISE RATE | MEASUREMENT WITH THERMOCOUPLE |
| | | HEATER OUTPUT | |
| | | HEATER TEMPERATURE ACCURACY | VARIATION IN MEASUREMENT VALUE |
| | | WORKPIECE TEMPERATURE ACCURACY | |
| | | HEATER TEMPERATURE/WORKPIECE TEMPERATURE (RESPONSE CHARACTERISTIC) | |
| | | HEATER TEMPERATURE DISTRIBUTION | |
| | | WORKPIECE TEMPERATURE DISTRIBUTION | |
| | | COOLANT GAS TYPE | Input |
| | | COOLANT GAS PRESSURE | PRESSURE IN CHAMBER |
| | | WORKPIECE COOLING RATE | FILM STRESS |
| | EVAPORATION SOURCE SYSTEM (THIRD PARAMETER) | TARGET COMPOSITION | Input |
| | | TARGET THICKNESS | Input |
| | | TARGET MANUFACTURING METHOD | Input |
| | | ARC DISCHARGE VOLTAGE | |
| | | ARC DISCHARGE CURRENT | |
| | | EVAPORATION SOURCE MAGNETIC FIELD (PERMANENT MAGNET CHARACTERISTIC) | MAGNET POSITION, STRENGTH, Input |
| | | EVAPORATION SOURCE COIL CURRENT | |
| | | ARC IGNITION CHARACTERISTIC (VOLTAGE/CURRENT BEHAVIOR) | DETECTION OF TARGET SURFACE STATE |
| | ETCHING SYSTEM (SIXTH PARAMETER) | FILAMENT HEATING CURRENT | |
| | | FILAMENT HEATING VOLTAGE | |
| | | FILAMENT DIAMETER | CAN BE OBTAINED ALSO BY Input CALCULATION |
| | | DISCHARGE CURRENT | DISCHARGE CURRENT OF FILAMENT |
| | | DISCHARGE VOLTAGE | DISCHARGE VOLTAGE OF FILAMENT |
| | TABLE SYSTEM (FOURTH PARAMETER) | BIAS VOLTAGE | |
| | | BIAS CURRENT | |
| | | NUMBER OF TIMES OF OL | OverLoad ABNORMAL DISCHARGE (BETWEEN TOOL AND CHAMBER) |
| | | OL TIME CHANGE | |
| | | BIAS VOLTAGE WAVEFORM | AT THE TIME OF PULSE BIAS IN PARTICULAR |
| | | BIAS CURRENT WAVEFORM | |
| | | WORKPIECE ROTATION SPEED | |
| | | WORKPIECE SHAPE | Input |
| | | WORKPIECE LOAD AMOUNT | Input |
| | | WORKPIECE LOAD METHOD | Input |
| | | WORKPIECE MATERIAL | Input |
| | PROCESS GAS SYSTEM (FIFTH PARAMETER) | GAS FLOW RATE | |
| | | GAS TYPE | |
| | | GAS PRESSURE | |

# FIG.5

| FILM FORMATION EVALUATION | | |
|---|---|---|
| MIDDLE CLASSIFICATION | SMALL CLASSIFICATION | |
| FILM QUALITY CHARACTERISTIC | FILM THICKNESS | FILM THICKNESS MEASURING INSTRUMENT |
| | ROUGHNESS | ROUGHNESS METER |
| | SURFACE TEXTURE | MICROSCOPE/ROUGHNESS METER |
| | COMPOSITION | X-RAY SPECTROMETRY |
| | CRYSTAL STRUCTURE | X-RAY DIFFRACTOMETRY/ELECTRON MICROSCOPE OBSERVATION |
| | FILM MICROSTRUCTURE | X-RAY DIFFRACTOMETRY/ELECTRON MICROSCOPE OBSERVATION |
| | CRYSTALLINITY | X-RAY DIFFRACTOMETRY/ELECTRON MICROSCOPE OBSERVATION |
| | CRYSTAL GRAIN SIZE | X-RAY DIFFRACTOMETRY/ELECTRON MICROSCOPE OBSERVATION |
| | RESIDUAL STRESS | X-RAY DIFFRACTOMETRY/ELECTRON MICROSCOPE OBSERVATION |
| | DENSITY | X-RAY REFLECTION METHOD |
| | PARTICLE AMOUNT | MICROSCOPE/IMAGE PROCESSING |
| | PARTICLE SIZE | MICROSCOPE/IMAGE PROCESSING |
| MECHANICAL CHARACTERISTIC | HARDNESS | HARDNESS TESTER/NANOINDENTER |
| | ELASTIC MODULUS | NANOINDENTER |
| | WEAR RESISTANCE | SLIDING TEST |
| | EROSION RESISTANCE CHARACTERISTIC | GRIND AMOUNT BY SANDBLASTING |
| | HIGH-TEMPERATURE STRENGTH | NANOINDENTER |
| | HIGH-TEMPERATURE CREEP | NANOINDENTER |
| PHYSICAL CHARACTERISTIC | FRICTION COEFFICIENT | SLIDING TEST |
| | OXIDATION RESISTANCE | X-RAY DIFFRACTOMETRY/COMPOSITION ANALYSIS |
| | ADHESION | INDENTATION METHOD/SCRATCH TEST |
| | THERMAL CONDUCTIVITY | THERMAL CONDUCTIVITY MEASUREMENT |

# FIG.6

| FILM FORMATION EVALUATION | | |
|---|---|---|
| MIDDLE CLASSIFICATION | SMALL CLASSIFICATION | |
| FILM QUALITY CHARACTERISTIC | FILM THICKNESS | FILM THICKNESS MEASURING INSTRUMENT |
| | ROUGHNESS | ROUGHNESS METER |
| | SURFACE TEXTURE | MICROSCOPE/ROUGHNESS METER |
| | COMPOSITION | X-RAY SPECTROMETRY |
| | CRYSTAL STRUCTURE | X-RAY DIFFRACTOMETRY/ELECTRON MICROSCOPE OBSERVATION |
| | FILM MICROSTRUCTURE | X-RAY DIFFRACTOMETRY/ELECTRON MICROSCOPE OBSERVATION |
| | CRYSTALLINITY | X-RAY DIFFRACTOMETRY/ELECTRON MICROSCOPE OBSERVATION |
| | CRYSTAL GRAIN SIZE | X-RAY DIFFRACTOMETRY/ELECTRON MICROSCOPE OBSERVATION |
| | RESIDUAL STRESS | X-RAY DIFFRACTOMETRY/ELECTRON MICROSCOPE OBSERVATION |
| | DENSITY | X-RAY REFLECTION METHOD |
| | PARTICLE AMOUNT | MICROSCOPE/IMAGE PROCESSING |
| | PARTICLE SIZE | MICROSCOPE/IMAGE PROCESSING |
| PHYSICAL CHARACTERISTIC | ADHESION | INDENTATION METHOD/SCRATCH TEST |
| | OPTICAL CHARACTERISTIC | SPECTROPHOTOMETRIC COLORIMETER |

# FIG.7

| PHYSICAL QUANTITY | | | PROTECTIVE FILM APPLICATION | | |
|---|---|---|---|---|---|
| | | | WEAR RESISTANT APPLICATION | CORROSION RESISTANT APPLICATION | HEAT RESISTANT APPLICATION |
| MIDDLE CLASSIFICATION | SMALL CLASSIFICATION | | | | |
| FILM QUALITY CHARACTERISTIC | FILM THICKNESS | FILM THICKNESS MEASURING INSTRUMENT | O | O | O |
| | ROUGHNESS | ROUGHNESS METER | O | O | O |
| | SURFACE TEXTURE | MICROSCOPE/ROUGHNESS METER | O | O | O |
| | COMPOSITION | X-RAY SPECTROMETRY | O | O | O |
| | CRYSTAL STRUCTURE | X-RAY DIFFRACTOMETRY/ELECTRON MICROSCOPE OBSERVATION | O | O | O |
| | FILM MICROSTRUCTURE | X-RAY DIFFRACTOMETRY/ELECTRON MICROSCOPE OBSERVATION | O | O | O |
| | CRYSTALLINITY | X-RAY DIFFRACTOMETRY/ELECTRON MICROSCOPE OBSERVATION | O | O | O |
| | CRYSTAL GRAIN SIZE | X-RAY DIFFRACTOMETRY/ELECTRON MICROSCOPE OBSERVATION | O | O | O |
| | RESIDUAL STRESS | X-RAY DIFFRACTOMETRY/ELECTRON MICROSCOPE OBSERVATION | O | O | O |
| | DENSITY | X-RAY REFLECTION METHOD | O | O | O |
| | PARTICLE (DEFECT) AMOUNT | MICROSCOPE/IMAGE PROCESSING | O | O | O |
| | PARTICLE (DEFECT) SIZE | MICROSCOPE/IMAGE PROCESSING | O | O | O |
| MECHANICAL CHARACTERISTIC | HARDNESS | HARDNESS TESTER/NANOINDENTER | O | – | O |
| | ELASTIC MODULUS | NANOINDENTER | O | – | O |
| | WEAR RESISTANCE | SLIDING TEST | O | – | – |
| | EROSION RESISTANCE CHARACTERISTIC | GRIND AMOUNT BY SANDBLASTING | O | – | – |
| | HIGH-TEMPERATURE STRENGTH | NANOINDENTER | O | – | O |
| | HIGH-TEMPERATURE CREEP | NANOINDENTER | O | – | O |
| PHYSICAL CHARACTERISTIC | FRICTION COEFFICIENT | SLIDING TEST | O | – | – |
| | OXIDATION RESISTANCE | X-RAY DIFFRACTOMETRY/COMPOSITION ANALYSIS | O | O | O |
| | ADHESION | INDENTATION METHOD/SCRATCH TEST | O | – | O |
| | THERMAL CONDUCTIVITY | THERMAL CONDUCTIVITY MEASUREMENT | O | – | O |
| | COHESION | SLIDING TEST/MICROSCOPE OBSERVATION | O | – | – |
| | CORROSION RESISTANCE | CORROSION SOLUTION SPRAY TEST/IMMERSION TEST | O | O | – |
| | CHEMICAL RESISTANCE | APPLICATION TEST/IMMERSION TEST | – | O | – |
| | SURFACE CHEMICAL AFFINITY | SURFACE CHEMICAL ANALYSIS | O | O | – |

# FIG.8

| FILM FORMATION EVALUATION | | |
|---|---|---|
| MIDDLE CLASSIFICATION | SMALL CLASSIFICATION | |
| FILM QUALITY CHARACTERISTIC | FILM THICKNESS | FILM THICKNESS MEASURING INSTRUMENT |
| | ROUGHNESS | ROUGHNESS METER |
| | SURFACE TEXTURE | MICROSCOPE/ROUGHNESS METER |
| | COMPOSITION | X-RAY SPECTROMETRY |
| | CRYSTAL STRUCTURE | X-RAY DIFFRACTOMETRY/ELECTRON MICROSCOPE OBSERVATION |
| | FILM MICROSTRUCTURE | X-RAY DIFFRACTOMETRY/ELECTRON MICROSCOPE OBSERVATION |
| | CRYSTALLINITY | X-RAY DIFFRACTOMETRY/ELECTRON MICROSCOPE OBSERVATION |
| | CRYSTAL GRAIN SIZE | X-RAY DIFFRACTOMETRY/ELECTRON MICROSCOPE OBSERVATION |
| | RESIDUAL STRESS | X-RAY DIFFRACTOMETRY/ELECTRON MICROSCOPE OBSERVATION |
| | DENSITY | X-RAY REFLECTION METHOD |
| | PARTICLE AMOUNT | MICROSCOPE/IMAGE PROCESSING |
| | PARTICLE SIZE | MICROSCOPE/IMAGE PROCESSING |
| MECHANICAL CHARACTERISTIC | HARDNESS | HARDNESS TESTER/NANOINDENTER |
| | ELASTIC MODULUS | NANOINDENTER |
| | WEAR RESISTANCE | SLIDING TEST |
| PHYSICAL CHARACTERISTIC | FRICTION COEFFICIENT | SLIDING TEST |
| | OXIDATION RESISTANCE | X-RAY DIFFRACTOMETRY/COMPOSITION ANALYSIS |
| | ADHESION | INDENTATION METHOD/SCRATCH TEST |
| | THERMAL CONDUCTIVITY | THERMAL CONDUCTIVITY MEASUREMENT |
| | COHESION | SLIDING TEST/MICROSCOPE OBSERVATION |
| | CORROSION RESISTANCE | CORROSION SOLUTION SPRAY TEST/IMMERSION TEST |
| | SURFACE CHEMICAL AFFINITY | SURFACE CHEMICAL ANALYSIS |

# FIG.9

## INTERNATIONAL SEARCH REPORT

International application No.

PCT/JP2020/027465

### A. CLASSIFICATION OF SUBJECT MATTER
Int. Cl. C23C14/54(2006.01)i, C23C14/32(2006.01)i
FI: C23C14/54, C23C14/32 Z

According to International Patent Classification (IPC) or to both national classification and IPC

### B. FIELDS SEARCHED

Minimum documentation searched (classification system followed by classification symbols)
Int. Cl. C23C14/54, C23C14/32

Documentation searched other than minimum documentation to the extent that such documents are included in the fields searched
Published examined utility model applications of Japan    1922-1996
Published unexamined utility model applications of Japan    1971-2020
Registered utility model specifications of Japan    1996-2020
Published registered utility model applications of Japan    1994-2020

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| Y | JP 2013-44047 A (KOBE STEEL, LTD.) 04 March 2013, paragraphs [0012], [0013], [0018]-[0023], [0040], [0043]-[0046], [0051]-[0062], fig. 1, 2, 4, 5 | 1-14 |
| Y | JP 2019-40984 A (HITACHI, LTD.) 14 March 2019, paragraphs [0002]-[0006], [0009], [0033]-[0052], fig. 2 | 1-14 |
| Y | JP 2004-83975 A (KOBE STEEL, LTD.) 18 March 2004, paragraphs [0003], [0011]-[0017] | 2, 8 |
| A | | 1, 3-7, 9-14 |
| Y | JP 2015-224348 A (KOBE STEEL, LTD.) 14 December 2015, paragraphs [0009], [0020], [0021] | 8 |
| A | | 1-7, 9-14 |

☒ Further documents are listed in the continuation of Box C.  ☒ See patent family annex.

| | | |
|---|---|---|
| * Special categories of cited documents: | "T" | later document published after the international filing date or priority date and not in conflict with the application but cited to understand the principle or theory underlying the invention |
| "A" document defining the general state of the art which is not considered to be of particular relevance | | |
| "E" earlier application or patent but published on or after the international filing date | "X" | document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" document referring to an oral disclosure, use, exhibition or other means | | |
| "P" document published prior to the international filing date but later than the priority date claimed | "&" | document member of the same patent family |

| Date of the actual completion of the international search | Date of mailing of the international search report |
|---|---|
| 09.09.2020 | 24.09.2020 |

| Name and mailing address of the ISA/ | Authorized officer |
|---|---|
| Japan Patent Office 3-4-3, Kasumigaseki, Chiyoda-ku, Tokyo 100-8915, Japan | |
| | Telephone No. |

Form PCT/ISA/210 (second sheet) (January 2015)

**INTERNATIONAL SEARCH REPORT**

International application No.

PCT/JP2020/027465

C (Continuation).   DOCUMENTS CONSIDERED TO BE RELEVANT

| Category* | Citation of document, with indication, where appropriate, of the relevant passages | Relevant to claim No. |
|---|---|---|
| Y<br>A | JP 2019-86468 A (NTT FACILITIES, INC.) 06 June<br>2019, paragraphs [0055]-[0074] | 10<br>1-9, 11-14 |
| Y<br>A | WO 2018/039251 A1 (ORACLE INTERNATIONAL<br>CORPORATION) 01 March 2018, paragraph [0034] | 10<br>1-9, 11-14 |
| E, X | JP 6737944 B1 (KOBE STEEL, LTD.) 12 August 2020,<br>claims 1-8, 10-13 | 1-8, 11-14 |

Form PCT/ISA/210 (continuation of second sheet) (January 2015)

| Patent Documents referred to in the Report | Publication Date | Patent Family | Publication Date |
| --- | --- | --- | --- |
| JP 2013-44047 A | 04.03.2013 | US 2014/0110253 A1 paragraphs [0036], [0037], [0088]-[0090], [0101], [0111]-[0118], fig. 3, 6-8 EP 2730677 A1 CN 103649370 A KR 10-2014-0025550 A | |
| JP 2019-40984 A | 14.03.2019 | US 2019/0064751 A1 paragraphs [0003]-[0009], [0056]-[0072], fig. 2 KR 10-2019-0022289 A | |
| JP 2004-83975 A | 18.03.2004 | (Family: none) | |
| JP 2015-224348 A | 14.12.2015 | (Family: none) | |
| JP 2019-86468 A | 06.06.2019 | (Family: none) | |
| WO 2018/039251 A1 | 01.03.2018 | JP 2019-532366 A US 2018/0052861 A1 EP 3500980 A1 CN 108701255 A | |
| JP 6737944 B1 | 12.08.2020 | (Family: none) | |

Form PCT/ISA/210 (patent family annex) (January 2015)

**REFERENCES CITED IN THE DESCRIPTION**

**Patent documents cited in the description**

- JP 2014114507 A